# EUROPÄISCHE PATENTSCHRIFT

(11) **EP 0 990 912 B1**
(45) Veröffentlichungstag und Bekanntmachung des Hinweises auf die Patenterteilung: **28.02.2007**
(21) Anmeldenummer: 99118797.2
(22) Anmeldetag: 23.09.1999
(51) Int. Cl.: G01R 1/067, G01R 1/073

(54) **Prüfsonde-Antriebsvorrichtung**
Test probe actuator
Actionneur pour une sonde de test

(30) Priorität: 28.09.1998 DE 19844428
(43) Veröffentlichungstag der Anmeldung: 05.04.2000
(60) Teilanmeldung: 06001020.4
(73) Patentinhaber: atg test systems GmbH, 97877 Wertheim (DE)
(72) Erfinder: Prokopp, Manfred, 97877 Wertheim-Reicholzheim (DE); Stoehr, Roland, 71154 Nufringen (DE)
(74) Vertreter: Ganahl, Bernhard

(56) Entgegenhaltungen:
- EP-A- 0 068 270
- EP-A- 0 396 292
- EP-A- 0 784 252
- US-A- 4 963 822
- US-A- 5 367 254
- US-A- 5 532 611
- US-A- 5 804 982
- PATENT ABSTRACTS OF JAPAN vol. 016, no. 147 (P-1336), 13. April 1992 (1992-04-13) -& JP 04 002969 A (NEC CORP), 7. Januar 1992 (1992-01-07)
- PATENT ABSTRACTS OF JAPAN vol. 018, no. 223 (P-1729), 21. April 1994 (1994-04-21) & JP 06 018558 A (HITACHI LTD), 25. Januar 1994 (1994-01-25)
- PATENT ABSTRACTS OF JAPAN vol. 015, no. 382 (P-1257), 26. September 1991 (1991-09-26) & JP 03 152481 A (NEC CORP), 28. Juni 1991 (1991-06-28)

## Beschreibung

Die Erfindung betrifft eine Prüfsonde für einen Fingertester.

Prüfvorrichtungen zum Testen von Leiterplatten können grundsätzlich in zwei Gruppen eingeteilt werden, nämlich den Fingertestern und den Paralleltestem. Die Paralleltester sind Prüfvorrichtungen, die mittels eines Adapters alle oder zumindest die meisten Kontaktstellen einer zu prüfenden Leiterplatte gleichzeitig kontaktieren. Fingertester sind Prüfvorrichtungen zum Testen von unbestückten oder bestückten Leiterplatten, die mit zwei oder mehreren Prüffingem die einzelnen Kontaktstellen sequentiell abtasten.

Die Prüffinger sind in der Regel an einem Schlitten befestigt, welcher entlang von Traversen verfahrbar ist, wobei die Traversen wiederum auf Führungsschienen geführt und verfahrbar sind. Die Schlitten können somit an jede beliebige Stelle eines in der Regel rechteckförmigen Prüffeldes positioniert werden. Zum Kontaktieren einer Kontaktstelle der zu prüfenden Leiterplatte ist der Schlitten an der Traverse vertikal verschieblich, so daß der Prüffinger von oben bzw. unten auf die Kontaktstelle der Leiterplatte gesetzt werden kann.

Ein Fingertester ist in der EP 0 468 153 A1 und ein Verfahren zum Prüfen von Leiterplatten mittels eines Fingertesters ist in der EP 0 853 242 A1 beschrieben.

Aus der US 5,113,133 ist eine Prüfsonde bekannt, bei der eine als Sondenelement dienende Blattfeder in einem Kanal geführt ist. Das Sondenelement kann zum Kontaktieren der Oberfläche eines Prüflings in diesem Kanal nach unten verschoben werden, wobei sie mit einer Spitze aus dem Kanal ausfährt und eine Kontaktstelle des Prüflings kontaktiert. Mit dem zur Spitze der Blattfeder gegenüberliegendem Ende der Kontaktfeder ist diese an einer drehbaren Scheibe befestigt, wobei bei einer Drehung der Scheibe sich die Blattfeder von dieser ab- bzw. auf diese aufwickelt. Somit kann durch Drehen der Scheibe die Blattfeder im Kanal vertikal auf und ab bewegt werden.

Der Kanal ist mit einer Ausnehmung versehen, in welcher die Blattfeder ausbiegen kann, so daß die bei der "Landung" auf der Oberfläche des Prüflings auftretende Reaktionskraft absorbiert wird.

Mit dieser Sonde soll ein schneller Kontakt zwischen dem Sondenelement und einer Kontaktstelle des Prüflings erzielt werden, wobei gleichzeitig das Auftreffen des Sondenelementes auf der Oberfläche des Prüflings zu keinen Beschädigungen desselben führen soll.

Die US 5,804,982 beschreibt eine Prüfsonde für ein Testgerät zum Testen von Mikrochips. Die Prüfsonde weist einen Aktuator auf, der eine Sondenspitze vertikal verstellen kann. Der Aktuator besteht aus zwei Spulen, die horizontal liegend angeordnet sind, und zwei seitlich davon angeordneten Magneten. Dieser Aktuator bewegt zwei elastische Hebelarme, die an einem Ende ortsfest angeordnet sind und an deren anderen Enden ein Halterelement befestigt ist, an dem wiederum das Kontaktelement angeordnet ist. Bei dieser bekannten Prüfsonde wird die Sondenspitze zusammen mit dem Halterelement entgegen der Federwirkung der elastischen Hebelarme bewegt.

Aus der US 5,367,254 geht eine Anordnung von Kontaktelementen zum Testen von Halbleiterbauelementen hervor, die ein modular aufgebauter Adapter ist. Bei diesem Adapter sind dünne Drähte in parallel nebeneinander liegenden Röhren angeordnet. Die Röhren sind mit Ausnehmungen versehen, in welchen die Drähte bei Belastung ausbiegen können. Das Verwenden solcher Drähte erlaubt eine sehr dichte Anordnung der Sonden, die zugleich federnd sind, um elastisch Kontaktstellen eines Halbleiterbauteils zu kontaktieren.

Das wesentliche Kriterium um Fingertester am Markt erfolgreich durchsetzen zu können, ist die Geschwindigkeit, mit der die Kontaktstellen des Prüflings kontaktiert werden können. Herkömmliche Fingertester benötigen für eine Vertikalbewegung des Prüffingers ca. 120 ms. Die aus der US 5,113,133 bekannte Prüfsonde ist schneller und benötigt nur noch einige 10 ms für eine Vertikalbewegung.

Aus Patent Abstracts of Japan, Ausgabe 16, Nr. 147 (P-1336), vom 13. April 1992 zu der japanischen Patentanmeldung JP 04 002969 A ist eine Prüfsonde bekannt, die auf einer Führungsschiene verschieblich lagert und mittels eines Magneten und Bewegungsspulen bewegt wird. Zur Bestimmung der Position der Sonde ist ein Detektor vorgesehen.

Ein Beispiel, das das Verständnis der Erfindungs erleichtert, weist eines Aktuator mit einem permanent vormagnetisierten Kern und einem Spulenelement auf, die relativ zueinander beweglich sind, wobei eines der beiden Teile fixiert und das andere beweglich ist, und das bewegliche Teil mechanisch mit einem Sondenelement verbunden ist, so daß bei Stromschaltung das bewegliche Teil zusammen mit dem Sondenelement bewegt wird.

Das Beispiel zeichnet sich dadurch aus, daß das bewegliche Teil frei beweglich an dem fixierten Teil angeordnet ist, d.h., daß es keine mechanische Verbindung zwischen dem beweglichen Teil und dem fixierten Teil gibt. Lediglich ein elektrischer Leiter zum elektrischen Anschließen des Sondenelementes an eine Prüfvorrichtung ist zwischen dem fixierten und dem beweglichen Teil vorgesehen, der jedoch so ausgebildet ist, daß er keinen oder nur geringste, zu vernachlässigende Kräfte zwischen dem beweglichen und fixiertem Teil übertragen kann. Hierdurch kann das bewegliche Teil ohne Überwindung eines mechanischen Widerstandes schnell bewegt werden. Zudem ist das Sondenelement ein elastischer Draht, der in einem Führungskanal geführt ist, der mit zumindest einer Ausnehmung versehen ist, in welche der Draht bei Belastung ausbiegen kann, wodurch trotz der sehr schnellen Bewegung des Sondenelements bei Betätigung des Aktuators die auf die zu testende Leiterplatte ausgeübte Belastung gering gehalten wird.

Der Erfindung liegt die Aufgabe zugrunde, eine Prüfsonde für einen Fingertester zu schaffen, die einfach aufgebaut ist und sehr schnell ein Sondenelement zur Kontaktierung einer Kontaktstelle eines Prüflings bewegen kann, wobei die maximal auf eine zu prüfende Leiterplatte auszuübende Kraft begrenzt wird.

Die Aufgabe wird durch eine Prüfsonde für einen Fingertester mit den Merkmalen des Anspruchs 1 gelöst. Vorteilhafte Ausgestaltungen sind in den Unteransprüchen angegeben.

Der elastische Draht ist in einem Führungskanal geführt, der mit mehreren Ausnehmungen versehen ist, in welche der Draht bei Belastung ausbiegen kann. Es hat sich gezeigt, daß bei einer solchen Prüfsonde die vom Draht auf eine Kontaktstelle ausgeübt Kraft zunächst etwa proportional mit dem Betätigungsweg ansteigt und ab einem vorbestimmten Betätigungsweg kaum mehr zunimmt. Dieser Effekt begrenzt die maximal auf eine zu prüfende Leiterplatte auszuübende Kraft.

### Dieser Effekt ergibt sich, erfindungsgemäß aus folgendem:

Zum Ausbiegen des Drahtes in eine erste Ausnehmung ist eine vorbestimmte Kraft notwendig, die proportional zum Betätigungsweg, um welchen der Draht vom Aktuator verschoben wird, ist und durch die Steifigkeit des Drahtes und der Geometrie der Ausnehmung festgelegt wird. Ist der Draht in eine erste Ausnehmung ausgebogen, so wird er bei einer weiteren Betätigung des Aktuators in eine zweite oder dritte Ausnehmung ausgebogen, wobei die hier vom Aktuator aufzubringende Kraft bzw. die von der Kontaktstelle aufzubringende Gegenkraft der zum Ausbiegen in die erste Ausnehmung notwendigen Kraft entspricht. Der weitere, sehr geringfügige Anstieg der Kräfte wird durch die zusätzliche Reibung zwischen dem Draht und dem Führungskanal verursacht. Durch diese Ausbildung der Prüfsonde ist die maximal durch das Sondenelement auf die Kontaktstelle einer Leiterplatte ausgeübte Kraft auf einen vorbestimmten Wert begrenzt. Diese Begrenzung der Kraft erfolgt konstruktiv, weshalb bei der Ansteuerung des Sondenelementes zum Kontaktieren der Kontaktstelle keine Begrenzung der Zustellgeschwindigkeit notwendig ist, wie es von herkömmlichen Fingertestern bekannt ist.

Nach einer bevorzugten Ausführungsform der Erfindung ist der permanent vormagnetisierte Kern fixiert und das Spulenelement bildet das bewegliche Teil, das mechanisch mit dem Sondenelement verbunden ist. Da das Spulenelement und nicht der Kern bewegt wird, kann die Masse der beweglichen Teile und damit die Trägheit des Aktuators gering gehalten werden. Hierdurch kann eine außergewöhnlich schnelle Bewegung der Sonde erzielt werden.

Zudem nimmt das Spulenelement bei einer Ansteuerung des Aktuators, wie sie in Anspruch 15 angegeben ist, jeweils eine Null-Stellung und eine Kontaktstellung durch Stromschaltung mit einer vorbestimmten Polarität ein. Das Umschalten der Polarität geht schlagartig vonstatten, weshalb auch das Spulenelement entsprechend schlagartig angesteuert werden kann. Zudem ist zum Halten des Spulenelementes in der Null-Stellung kein Federelement oder dgl. notwendig, wie es bei herkömmlichen elektromagnetischen Aktuatoren vorgesehen wird. Solche Federelemente erhöhen die Trägheit des Aktuators, weshalb das Halten der Null-Stellung mittels eines Haltestroms eine Verbesserung des Ansprechverhaltens bewirkt.

Ein weiteres vorteilhaftes Prinzip der vorliegenden Erfindung ist in Anspruch 16 angegeben, gemäß dem ein Fingertester eine Einrichtung zum Verstellen der vertikalen Position der Prüfsonde aufweist und die Prüfsonde mit einem Aktuator versehen ist, der ein Sondenelement unabhängig von der Einrichtung zum Verstellen der vertikalen Position der Prüfsonde in Vertikalrichtung zum Kontaktieren einer Kontaktstelle einer Leiterplatte betätigen kann.

Durch die Einrichtung zum Verstellen der vertikalen Position der Prüfsonde wird eine Grobjustierung der Prüfsonde bzgl. einer zu prüfenden Leiterplatte vorgenommen, wobei der Abstand zwischen der Leiterplatte und der Prüfsonde vorzugsweise auf einen kleinen Wert, wie z.B. kleiner als 2 mm bzw. kleiner als 1 mm eingestellt wird. Hierdurch muß der Aktuator lediglich um diesen kurzen Abstand zwischen der Leiterplatte und der Prüfsonde das Sondenelement verschieben, was wesentlich einfacher und schneller ausgeführt werden kann, als wenn die üblichen Abstände zwischen einer Ausgangsposition eines Testfingers und einer zu prüfenden Leiterplatte von einigen Millimetern überwunden werden müssen.

Wegen der sehr schnellen Kontaktierung einer Kontaktstelle ist die erfindungsgemäße Prüfsonde besonders zum Testen von unbestückten Leiterplatten geeignet, bei welchen eine sehr große Anzahl von Leiterplattentestpunkten geprüft werden müssen. Die erfindungsgemäße Prüfsonde kann jedoch auch zum Testen von bestückten Leiterplatten eingesetzt werden.

Nachfolgend wird die Erfindung beispielhaft näher anhand der beigefügten Zeichnungen erläutert. Es zeigen:
- Fig. 1: einen vertikalen Schnitt durch eine erfindungsgemäße Prüfsonde und eines Teils des Schlittens des Fingertesters, an dem die Prüfsonde befestigt ist,

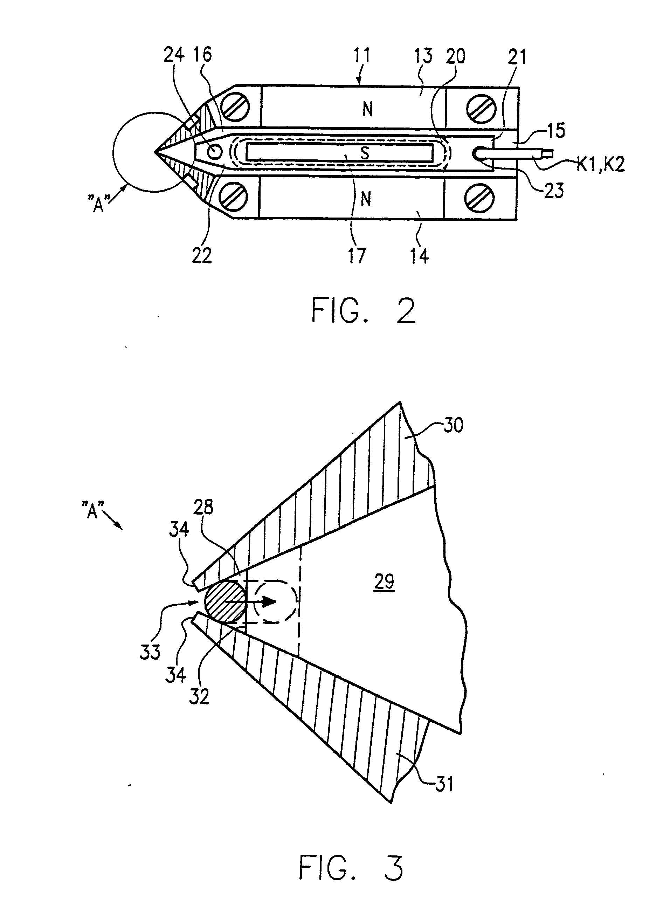

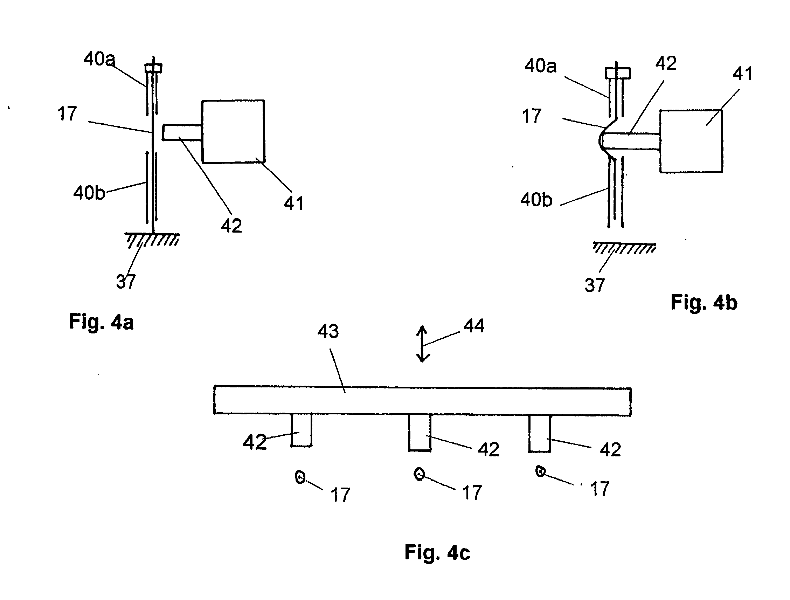

- Fig. 2: einen Querschnitt durch die in Fig. 1 gezeigte Prüfsonde entlang der Linie A-A und mit Blickrichtung entlang der Pfeile, und
- Fig. 3: eine vergrößerte Ansicht eines in Fig. 2 gezeigten Führungskanals für einen Draht.

Die erfindungsgemäße Prüfsonde 1 ist für einen Fingertester vorgesehen, der einen Schlitten 2 aufweist. Der Schlitten 2 ist in an sich bekannter Weise parallel zu einem Prüffeld (in X- und Y-Richtung) verfahrbar und weist eine Einrichtung zum vertikalen Verschieben (in Richtung des Doppelpfeils 3) auf.

Der Schlitten 2 ist mit einer Aufnahme 4 zum Befestigen der Prüfsonde 1 versehen. An der Aufnahme 4 des Schlittens 2 ist die Prüfsonde mittels einer Halterung 5 lösbar befestigt, wobei im dargestellten Ausführungsbeispiel die Prüfsonde mittels einer Schraubverbindung am Schlitten 2 befestigt ist.

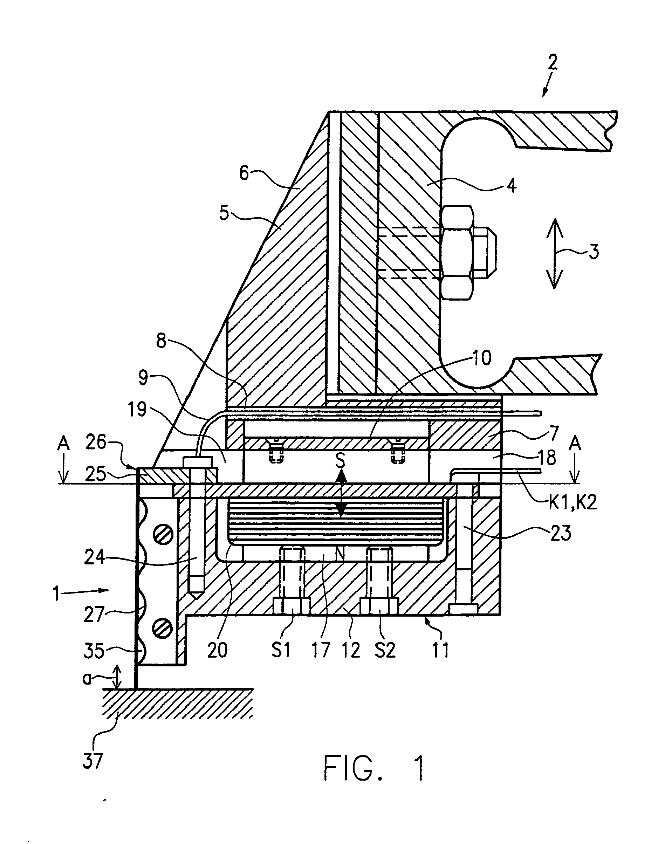

Bei dem in Fig. 1 gezeigten Ausführungsbeispiel erstreckt sich die Prüfsonde 1 vom Schlitten 2 nach unten. Diese Anordnung wird zum Kontaktieren einer elektrischen Leiterplatte von oben verwendet. Gleichermaßen ist es möglich, eine Leiterplatte von unten zu kontaktieren, wobei dann eine umgekehrte Anordnung von Schlitten 2 und Prüfsonde 1 verwendet wird. Es gibt auch Fingertester, die eine Leiterplatte an beiden Seiten testen und sowohl ober- als auch unterhalb der Leiterplatte Prüfsonden aufweisen. Bei der folgenden Beschreibung werden die Begriffe "oben" und "unten" entsprechend der in Fig. 1 gezeigten Anordnung verwendet.

Die Halterung 5 weist eine vertikale, in der Seitenansicht etwa L-förmige Wandung 6 auf, die einen sich unter die Aufnahme 4 erstreckenden Schenkel 7 besitzt. In diesem Schenkel 7 ist eine horizontale, dünne Durchgangsbohrung 8 eingebracht, durch die ein Sondenkabel 9 geführt ist. Am unteren Rand der vertikalen Wandung 6 ist eine horizontale Halteplatte 10 vorgesehen. Die Halteplatte 10 besteht vorzugsweise aus einem weichmagnetischen Material, wobei es aus Fertigungsgründen zweckmäßig sein kann, die gesamte Halterung 5 einteilig aus diesem Material zu fertigen.

An die horizontale Halteplatte 10 ist von unten ein Sondengehäuse 11 angesetzt. Das Sondengehäuse 11 weist eine Bodenwandung 12, zwei Seitenwandungen 13, 14 und zwei Stirnwandungen 15, 16 auf. Die Seitenwandungen 13, 14 sind höher als die Stirnwandungen 15, 16, so daß zwischen den Oberkanten der Stirnwandungen 15, 16 und der Halteplatte 10 jeweils ein Durchgangsspalt 18, 19 ausgebildet ist.

Parallel zu den Seitenwandungen 13, 14 ist ein plattenförmiger Eisenkern 17 vorgesehen, der wie die Bodenwandung 12 und die Halteplatte 10 aus einem weichmagnetischen Material besteht. Der Eisenkern 17 ist an der Bodenwandung 12 mittels zweier Schrauben S1, S2 befestigt.

Die Oberkante des Eisenkerns 17 fluchtet vorzugsweise mit den Oberkanten der Seitenwandungen 13, 14, so daß der Eisenkern beim Befestigen des Gehäuses 11 an der Halteplatte 10 gegen diese gedrückt und mit dieser in Berührung steht.

Die Seitenwandungen 13, 14 sind als Permanentmagnete ausgebildet, wobei sie z.B. mit ihrem Nordpol N nach oben weisend angeordnet sind. Die beiden Magnete 13, 14 sind durch die Bodenwandung 12 und die Halteplatte 10 magnetisch mit dem Kern 17 verbunden. Der Kern 17 wird hierdurch permanent vormagnetisiert, wobei er eine zu den Magneten 13, 14 entgegengesetzte Polanordnung aufweist. Bei dem in Fig. 1 gezeigten Ausführungsbeispiel weist der Kern im Bereich seiner Oberkante einen Südpol S und im Bereich seiner Unterkante einen Nordpol N auf.

Der Eisenkern 17 ist in dem durch die Wandungen 12 bis 16 begrenzten Hohlraum etwa zentriert angeordnet, so daß zwischen dem Eisenkern 17 und den beiden Stirnwandungen 15, 16 und den beiden Seitenwandungen 13, 14 jeweils ein Zwischenraum ausgebildet ist.

In dem Zwischenraum zwischen dem Eisenkern 17 und den ihn umgebenden Wandungen 13 bis 16 ist ein Spulenelement 20 eingesetzt. Das Spulenelement 20 sitzt frei beweglich auf dem Eisenkern 17, d.h., es besteht keinerlei mechanische Verbindung zwischen dem Eisenkern 17 und dem Spulenelement 20. Das Spulenelement 20 besteht aus einem rohrförmigen Trägerkörper, um den die Spule gewickelt ist. Der rohrförmige Trägerkörper weist einen flachen Querschnitt auf, so daß er den Eisenkern mit ein wenig Spiel umfaßt. Der Trägerkörper ist im Bereich der Stirnseiten an seinen Oberkanten mit in den jeweiligen Durchgangsspalt 18, 19 vorstehenden Zungen 21, 22 ausgebildet. Der Trägerkörper ist aus einem dünnwandigen Aluminiumblech gefertigt, so daß er leicht ist und ein durch die Spule erzeugtes Magnetfeld kaum beeinflußt.

An den beiden Zungen ist jeweils ein Loch eingebracht, an denen je ein nach unten weisender Führungsstift 23, 24 befestigt ist. Die Führungsstifte 23, 24 sind in vertikalen, in den Stirnwandungen 15, 16 des Gehäuses 11 ausgebildeten Führungslöcher eingesetzt, so daß das Spulenelement 20 vertikal verschieblich geführt ist.

An der Zunge 21 sind zwei elektrische Kabel K1, K2 angeordnet, welche die Spule mit einer von einer Steuereinrichtung angesteuerten Stromversorgung verbinden. Die Kabel K1, K2 werden durch den Spalt 18 von dem Spulenelement 20 nach außerhalb des Gehäuses geführt.

Die Oberkanten der Stirnwandungen 15, 16 bilden einen Anschlag für die Zungen 21, 22 des Spulenelementes, wobei bei Betätigung der Prüfsonde (Fig. 1), d.h. Stromschaltung des Spulenelementes mit einem Strom bestimmter Polarität, die Zungen an den Anschlägen anliegen. Diese in Fig. 1 gezeigte Stellung wird als Kontakt-Stellung bezeichnet, bei der ein Sondenelement 27 in Kontakt mit einer Kontaktstelle einer zu prüfenden Leiterplatte 37 steht.

Durch Stromschaltung des Spulenelementes 20 mit Strom einer entgegengesetzten Polarität zu derjenigen bei der Kontakt-Stellung wird das Spulenelement 20 nach oben gegen die Halteplatte 10 verschoben und nimmt eine Null-Stellung ein, bei der das Sondenelement 27 nicht in Kontakt mit einer der Kontaktstellen der zu prüfenden Leiterplatte steht.

Die Höhe der Durchgangsspalte 18, 19 begrenzt somit den maximalen Hub des Spulenelementes 20.

An der Zunge 21 des Trägerkörpers werden die elektrischen Leitungen der Spule durch den Durchgangsspalt 18 aus dem Gehäuse 11 herausgeführt. Die gegenüberliegende Zunge 22 ist verjüngt ausgebildet und an der Oberseite mit einem Kontaktplättchen 25 versehen. Durch das Kontaktplättchen 25 erstreckt sich der Führungsstift 24 hindurch, wobei der Führungsstift 24, das Kontaktplättchen 25 und die Zunge 22 miteinander verlötet sind. An dieser Lötstelle ist auch das Sondenkabel 9, das in einem Bogen von der Durchgangsbohrung 8 zur Lötstelle geführt ist, mechanisch und elektrisch mit dem Kontaktplättchen 25 bzw. dem Führungsstift 24 verbunden.

Das Kontaktplättchen 25 steht über die Zunge 22 nach außen vor, d.h., daß es vom Gehäuse weggerichtet ist. An der vom Gehäuse 11 entfernten Kante weist das Kontaktplättchen 25 eine Klemmeinrichtung 26 auf, an welcher ein Draht 27 austauschbar festgeklemmt werden kann. Der Draht 27 ist mit einem seiner Enden an dem Kontaktplättchen 25 festgeklemmt und erstreckt sich von dem Kontaktplättchen 25 nach unten durch einen Führungskanal 28 hindurch.

Der Führungskanal 28 wird von einem Kunststoffkörper 29 und zwei Keramikplättchen 30, 31 begrenzt.

Der Kunststoffkörper 29 weist einen etwa dreiecksförmigen Querschnitt auf, wobei er mit einer Flachseite an der Stirnwandung 16 des Gehäuses 11 befestigt ist und die der von der Stirnwandung 16 entfernt angeordnete Kante des Kunststoffkörpers 29 zu einer schmalen Führungsfläche 32 abgeflacht ist.

Die Keramikplättchen 30, 31 sind an den beiden, an der Führungsfläche 32 angrenzenden Seitenflächen des Kunststoffkörpers 29, z.B. mittels einer Schraubverbindung, befestigt und stehen über die Führungsfläche 32 vor, so daß sie spitz aufeinander zu laufen, wobei sie mit ihren Endkanten 34 einen Spalt 33 begrenzen, der schmäler als die Dicke des Drahtes 27 ist. Die Keramikplättchen sind in Richtung zu ihren freien Endkanten 34 verjüngt.

Die Führungsfläche 32 ist in der Seitenansicht wellenförmig ausgebildet, so daß der Führungskanal 28 in regelmäßigem Abstand angeordnete Ausnehmungen 35 aufweist, deren Funktion unten näher erläutert wird.

Der Kunststoffkörper 29 und die Keramikplättchen 30, 31 bilden einen Sondenkopf 36, der mit der Oberkante der Stirnwandung 16 des Gehäuses 11 fluchtet und nach unten über die Außenfläche der Bodenwandung 12 des Gehäuses ein Stück vorsteht. Die harten Keramikplättchen 30, 31 bilden einen sicheren Schutz für den Sondenkopf, falls dieser mit einer an der Leiterplatte überstehenden Lötstelle oder dergleichen in Berührung kommt. Zudem sind die Keramikplättchen 30, 31 elektrisch isolierend, so daß sie einen elektrischen Fehlkontakt im Bereich des Sondenkopfes verhindern.

Nachfolgend wird die Funktionsweise der erfindungsgemäßen Prüfsonde für einen Fingertester erläutert.

In einer Ausgangsstellung wird die Spule mit einem bestimmten Haltestrom angesteuert, wodurch das Spulenelement 20 um eine vorbestimmte Höhe h angehoben wird, so daß der Draht 27 in den Führungskanal 28 eingezogen wird. Das gesamte vertikale Bewegungsspiel des Spulenelementes 20 beträgt z.B. 1 mm.

Zur Betätigung der Prüfsonde wird das Spulenelement mit einem zum Haltestrom entgegengesetzt polarisierten Strom beaufschlagt, so daß durch das Magnetfeld des Kerns 17 eine auf das Spulenelement 20 nach unten gerichtete Kraft ausgeübt wird und das Spulenelement schlagartig nach unten bewegt wird, bis die Zungen 21, 22 an den Oberkanten der Stirnwandungen 15, 16 anschlagen.

Die zu bewegende Masse (Spulenelement, Kontaktplättchen, Führungsstifte und Draht) ist gering und zudem sind beim Übergang von der Null-Stellung in die Kontakt-Stellung wegen der freien Beweglichkeit des Spulenkörpers 20 keine mechanischen Kräfte zu überwinden, wie z.B. Federkräfte oder dgl., weshalb innerhalb von 5 ms und falls die gesamte zu bewegende Masse kleiner als 3 g ist, innerhalb von 2 ms ein Betätigungshub von 0,5 mm ausgeführt werden kann.

Nach dem Einlegen einer zu prüfenden Leiterplatte 37 in den Fingertester wird die Prüfsonde 1 durch Verschieben des Schlittens 2 vertikal bzgl. der Leiterplatte ausgerichtet. Hierbei wird ein Abstand a zwischen dem Sondenkopf 36 und der Leiterplatte 37 von z.B. kleiner oder gleich 0,5 mm eingestellt.

Die Prüfsonde 1 wird dann parallel zu der Oberfläche der zu prüfenden Leiterplatte verfahren, wobei bei Erreichen einer Kontaktstelle die Prüfsonde betätigt wird und das Sondenelement, der Draht 27, zur Herstellung eines elektrischen Kontaktes gegen die Kontaktstelle vertikal verschoben wird.

Für eine horizontale Bewegung von einer Kontaktstelle zu einer anderen Kontaktstelle werden üblicherweise etwa 50 ms benötigt. Für die vertikale Bewegung werden bei der erfindungsgemäßen Prüfsonde weniger als 5 ms benötigt, so daß die Vertikalbewegung nur einen geringen Zeitanteil von weniger als 10% an der Gesamtbewegung verursacht. Bei herkömmlichen Fingertestern benötigte man für eine Vertikalbewegung etwa 120 ms.

Beim Betätigen der Prüfsonde wird der Draht 17 im Führungskanal 28 verschoben, bis er auf der Oberfläche der zu prüfenden Leiterplatte auftrifft. Das Spulenelement 20 setzt seine Bewegung zur Leiterplatte gerichtete Bewegung fort, bis es mit seinen Zungen an den Oberkanten der Stirnwandungen 15, 16 des Gehäuses anschlägt. Der Draht 27 wird hierdurch weiter in den Führungskanal 28 eingedrückt, wobei er sich zunächst in eine erste Ausnehmung 35 ausbiegt. Zum Ausbiegen des Drahtes ist eine bestimmte Kraft notwendig, die etwa proportional zum Betätigungsweg während des Ausbiegens ist. Nach dem Ausbiegen in eine erste Ausnehmung 35 kann, erfindungsgemäß sich der Draht 27 noch in eine zweite, eventuell dritte Ausnehmung ausbiegen. Die hierbei vom Spulenelement aufzubringenden Kräfte sind etwa gleich und werden nur geringfügig durch die zunehmenden Reibungskräfte zwischen dem Führungskanal 28 und dem Draht 27 erhöht.

Da an der Oberfläche der zu prüfenden Leiterplatte die entsprechende Gegenkraft anliegt, ist diese auf die zum Ausbiegen des Drahtes in eine der Ausnehmungen begrenzt. Bei dem in Fig. 1 gezeigten Ausführungsbeispiel wird ein Draht aus Federstahl oder einer Kupfer-Beryllium-Legierung, wie z.B. CuBe2, mit einem Durchmesser von 40 µm verwendet. Die maximal vom Draht 27 auf eine zu prüfende Leiterplatte ausgeübte Kraft entspricht etwa der Masse von ca. 12 g bis 15 g (0,12 N bis 0,15 N). Der Betrag dieser Kraft kann durch Verändern der Form der Ausnehmungen 35 eingestellt werden, wobei bei einer längeren Vertikalerstreckung der Ausnehmungen 35 die Kraft zum Ausbiegen des Drahtes 27 geringer ist und daher eine kleinere Kraftbegrenzung erzielt wird.

Durch diese Begrenzung der vom Draht 27 auf eine Leiterplatte 37 ausgeübten Kraft können sicher Schäden an den Kontaktstellen der zu prüfenden Leiterplatten aufgrund zu hoher Kontaktkräfte vermieden werden. Bei herkömmlichen Fingertestern wurde die Zustellgeschwindigkeit, mit welcher die Testfinger auf die Kontaktstellen zu bewegt wurden, begrenzt. Dies verursacht lange Zustellzeiten, die z.B. ca. 120 ms betragen.

Die erfindungsgemäße Prüfsonde ist zudem sehr kompakt ausgebildet, d.h., daß sie eine Länge von ca. 2,5 cm und eine Tiefe von 0,8 cm besitzt. Diese kompakte Ausbildung der Prüfsonde erlaubt, daß eine Vielzahl von Prüfsonden in einer Matrix mit einem Längsabstand von z.B. 3 cm und einem Querabstand von z.B. 1 cm angeordnet werden können, wobei jede Prüfsonde individuell aktiviert werden kann. Eine solche Matrix, die etwa die Größe eines Prüffeldes aufweist muß zum Kontaktieren einer beliebigen Kontaktstelle auf der Leiterplatte nicht weiter als 3 cm in Längsrichtung und nicht weiter als 1 cm in Querrichtung bewegt werden. Hierdurch wird die für die Horizontalbewegung notwendige Zeit drastisch reduziert und eine weitere Verkürzung der notwendigen Prüfzeit erzielt.

Bei einer solchen Matrixanordnung ist vorteilhaft, daß der Draht der Prüfsonde bei Belastung ausbiegt, wodurch Toleranzen im Abstand zwischen der zu prüfenden Leiterplatte und den einzelnen Prüfsonden ausgeglichen werden. Hierdurch müssen die einzelnen Prüfsonden nicht separat bzgl. der zu prüfenden Leiterplatte justiert werden.

Eine solche Matrixanordnung kann auch in mehrere, gegenseitig verschiebbare Teile aufgeteilt sein, so daß auch Kontaktpunkte auf der zu prüfenden Leiterplatte, die nicht im Raster der Teilmatrizen angeordnet sind, kontaktiert werden können.

Die Teilmatrizen können z.B. in zwei nebeneinanderliegende, rechteckförmige Teilmatrizen aufgeteilt sein, wobei beide Teilmatrizen oder nur eine Talmatrix und die zu prüfende Leiterplatte verschieblich angeordnet sind. Bei einer vorteilhaften Ausführungsform sind die Teilmatrizen ähnlich einem Schachbrettmuster ineinander verschachtelt, wobei die Prüfsonden der einen Matriz an den weißen Feldern und die Prüfsonden der anderen Matrix an den schwarzen Feldern des Schachbrettmusters angeordnet sind. Zwischen den benachbarten Prüfsonden sind jeweils freie Zwischenbereiche ausgebildet, welche eine gegenseitige Verschiebung der beiden Matrizen erlaubt.

Bei einer solchen Matrixanordnung können mehrere Sondenelemente von lediglich einem Aktuator betätigt werden.

Grundsätzlich ist es jedoch auch möglich, diese Art von Aktuator zur Betätigung lediglich eines einzigen Drahtes vorzusehen.

Die Erfindung ist oben anhand eines Ausführungsbeispiels beschrieben; die Erfindung ist jedoch nicht auf die konkrete Ausführungsform beschränkt. Im Rahmen der Erfindung ist es z.B. auch möglich, daß die Klemmeinrichtung 26 durch ein Steckelement mit entsprechendem Gegensteckelement ersetzt wird. Ferner können die magnetischen Teile 12, 13, 14, 17 des Gehäuses 11 in ein weiteres, dünnwandiges Schutzgehäuse eingebaut sein.

## Patentansprüche

1. Prüfsonde für einen Fingertester mit
einem Sondenelement (27) zum elektrischen Kontaktieren einer Kontaktstelle einer zu prüfenden Leiterplatte (37),
einem Aktuator mit einem permanent vormagnetisierten Kern (17) und einem Spulenelement (20) die relativ zueinander beweglich sind, wobei eines der beiden Teile fixiert und das andere Teil beweglich ist,
das bewegliche Teil mechanisch mit dem Sondenelement (27) verbunden ist, so daß bei Stromschaltung das bewegliche Teil zusammen mit dem Sondenelement (27) bewegt wird,
das bewegliche Teil frei beweglich am fixierten Teil angeordnet ist, und
**dadurch gekennzeichnet,**
**daß** das Sondenelement ein elastischer Draht (27) ist, der in einem Führungskanal (28) geführt ist, der mit mehreren Ausnehmungen (35) versehen ist, in welche der Draht bei Belastung ausbiegen kann, wobei die Steifigkeit des Drahtes und die Geometrie der Ausnehmung so festgelegt sind, daß bei Betätigung des Aktuators mit einer vorbestimmten Kraft der Draht (27) in eine erste Ausnehmung ausgebogen wird, und bei einer weiteren Betätigung des Aktuators der Draht in eine zweite Ausnehmung ausgebogen wird, wodurch die maximal durch das Sondenelement (27) auf die Kontaktstelle einer Leiterplatte ausgeübte Kraft auf einen vorbestimmten Wert begrenzt wird.

2. Prüfsonde nach Anspruch 1,
**dadurch gekennzeichnet,**
**daß** der permanent vormagnetisierte Kern (17) fixiert ist und
das Spulenelement beweglich und mit dem Sondenelement mechanisch verbunden ist.

3. Prüfsonde nach Anspruch 1 oder 2,
**dadurch gekennzeichnet,**
**daß** das Spulenelement (20) und das Sondenelement (27) Bestandteil einer in der Prüfsonde (1) beweglichen Einheit sind, deren Masse kleiner als 10 g und vorzugsweise kleiner als 5 g ist.

4. Prüfsonde nach einem der Ansprüche 1 bis 3,
**dadurch gekennzeichnet,**
**daß** das Spulenelement (27) vertikal verschieblich auf dem Kern (17) angeordnet ist.

5. Prüfsonde nach einem der Ansprüche 1 bis 4,
**dadurch gekennzeichnet,**
**daß** der Kern (17) ein Permanentmagnet ist.

6. Prüfsonde nach einem der Ansprüche 1 bis 4,
**dadurch gekennzeichnet,**
**daß** der Kern (17) aus weichmagnetischem Material ausgebildet ist und zumindest ein Magnet (13, 14) vorgesehen ist, der mit dem Kern (17) magnetisch verbunden ist, so daß der Kern (17) permanent vormagnetisiert ist, und
**daß** der Kern (17) zwischen zwei plattenförmigen Permanentmagneten (13, 14) angeordnet ist, wobei der Kern (17) und die Permanentmagnete (13, 14) an ihren Ober- und Unterkanten jeweils über ein Joch (10, 12) magnetisch miteinander verbunden sind.

7. Prüfsonde nach Anspruch 6,
**dadurch gekennzeichnet,**
**daß** die plattenförmigen Permanentmagnete (13, 14) Seitenwandungen und eines der beiden Joche (12) eine Bodenwandung eines Gehäuses (11) bilden, und
das andere Joch (10) eine horizontale Halteplatte einer an einem Schlitten (2) befestigbaren Halterung (5) bilden.

8. Prüfsonde nach einem der Ansprüche 1 bis 7,
**dadurch gekennzeichnet,**
**daß** das Spulenelement aus einem aus einem dünnen Aluminiumblech ausgebildeten rohrförmigen Trägerkörper und einer um den Trägerkörper gewickelten Spule besteht.

9. Prüfsonde nach einem der Ansprüche 1 bis 8,
**gekennzeichnet durch**,
einen Anschlag, der zur Begrenzung des Bewegungsweges des Spulenelementes (20) vorgesehen ist, so daß beim Bewegen des Spulenelementes zum Kontaktieren des Sondenelementes (27) mit einer Kontaktstelle einer zu prüfenden Leiterplatte das Spulenelement (20) gegen den Anschlag verschoben wird.

10. Prüfsonde nach einem der Ansprüche 1 bis 9,
**dadurch gekennzeichnet,**
**daß** die Dicke des Drahtes kleiner als 50 µm ist.

11. Prüfsonde nach Anspruch 10,
**dadurch gekennzeichnet,**
**daß** am Führungskanal (28) zumindest drei Ausnehmungen (35) vorgesehen sind, die mit einem regelmäßigen Abstand angeordnet sind.

12. Prüfsonde nach Anspruch 10 oder 11,
**dadurch gekennzeichnet,**
**daß** der Führungskanal (28) in einem Sondenkopf (36) ausgebildet ist, der einen Kunststoffkörper (29) und zwei Keramikplättchen (30, 31) aufweist.

13. Prüfsonde nach Anspruch 12,
**dadurch gekennzeichnet,**
**daß** der Kunststoffkörper (29) einen in der Draufsicht etwa dreiecksförmigen Querschnitt aufweist, wobei eine vertikal verlaufende Kante des Kunststoffkörpers (29) zu einer schmalen Führungsfläche (32) abgeflacht ist, und die Keramikplättchen (30, 31) an den an der Führungsfläche (32) angrenzenden Seitenflächen befestigt sind und an der Führungsfläche (32) vorstehen, wobei sie spitz aufeinander zulaufen, so daß die Führungsfläche (32) und die Keramikplättchen (30, 31) den Führungskanal (28) begrenzen.

14. Prüfsonde nach Anspruch 13,
**dadurch gekennzeichnet,**
**daß** die Führungsfläche (32) in der Seitenansicht wellenförmig ausgebildet ist, so daß der Führungskanal (28) mit den Ausnehmungen (28) versehen ist.

15. Verfahren zum Ansteuern einer Prüfsonde, wobei eine Prüfsonde nach einem der Ansprüche 1 bis 14 verwendet wird,
**dadurch gekennzeichnet,**
**daß** in einer Null-Stellung das Spulenelement mit einem konstanten Haltestrom versorgt wird, so daß das Spulenelement um einen vorbestimmten Hub gegenüber einer durch einen Anschlag begrenzten Kontakt-Stellung des Spulenelementes (20) verschoben ist, und
**daß** zum Kontaktieren einer Kontaktstelle einer Leiterplatte das Spulenelement (20) mit einem zum Haltestrom entgegengesetzt gepolten Strom beaufschlagt wird, so daß das Spulenlement (20) gegen den Anschlag verschoben wird.

16. Fingertester zum Prüfen von Leiterplatten mit
einer Prüfsonde, die nach einem der Ansprüche 1 bis 14 ausgebildet ist,
zumindest zwei horizontal über einem Prüffeld verfahrbaren Schlitten (2), an denen jeweils eine Prüfsonde befestigbar ist, und
einer Einrichtung zum Verstellen der vertikalen Position der Prüfsonde (1),
**dadurch gekennzeichnet,**
**daß** die Prüfsonde (1) einen Aktuator aufweist, der ein Sondenelement (27) unabhängig von der Einrichtung zum Verstellen der vertikalen Position der Prüfsonde (1) in Vertikalrichtung zum Kontaktieren einer Kontaktstelle einer Leiterplatte betätigen kann.

17. Fingertester nach Anspruch 16,
**dadurch gekennzeichnet,**
**daß** der zum Kontaktieren einer Kontaktstelle ausgeführte Arbeitshub des Aktuators kleiner als 2 mm und vorzugsweise kleiner als 1 mm ist.

18. Fingertester nach Anspruch 16 oder 17, wobei eine Vielzahl von Prüfsonden in einer Matrixanordnung vorgesehen sind, wobei die gesamte Matrixanordnung horizontal über einer zu prüfenden Leiterplatte bewegt wird, und jede Prüfsonde von einem Aktuator betätigbar ist, um jeweils ein Sondenelement in Vertikalrichtung zu betätigen, wobei die Prüfsonden unabhängig voneinander betätigbar und gemäß einem der Ansprüche 1 bis 14 ausgebildet sind.

19. Fingertester nach einem der Ansprüche 16 bis 18, wobei eine Vielzahl von Prüfsonden in einer Matrixanordnung vorgesehen sind, wobei die gesamte Matrixanordnung horizontal über einer zu prüfenden Leiterplatte bewegt wird, und jede Prüfsonde von einem Aktuator betätigbar ist, um jeweils ein Sondenelement in Vertikalrichtung zu betätigen, und daß das Sondenelement ein elastischer Draht ist, der in einem Führungskanal geführt ist, der mit zumindest einer Ausnehmung versehen ist, in welche der Draht bei Belastung ausbiegen kann.

20. Fingertester nach Anspruch 18 oder 19,
**dadurch gekennzeichnet,**
**daß** die Matrixanordnung in mehrere Teilmatrizen unterteilt ist, wobei die Teilmatrizen zueinander verschieblich ausgebildet sind.

21. Fingertester nach einem der Ansprüche 16 bis 20,
**dadurch gekennzeichnet,**
**daß** mehrere Sondenelemente von einem einzigen Aktuator betätigbar sind.

## Claims

1. A finger tester probe comprising
a probe element (27) for electrically contacting a contact point of a circuit board under test (37),
an actuator including a permanently premagnetized core (17) and a solenoid element (20) each movable relative to the other, whereby one of said two parts is fixed and the other part is movable,
said movable part being mechanically connected to the probe element (27), so that on being energized said movable part is moved together with said probe element (27),
said movable part being arranged freely movable relative to said fixed part,
**characterized in that**
said probe element is an elastic wire (27) guided in a guide passage (28) provided with several cavities (35) into which said wire is able to curve when loaded, the stiffness and the geometry of the cavity being thus determined, that in actuating the actuator with a predetermined load the wire (27) is curved into a first cavity, and with being further actuated by the actuator the wire is being curved into a second cavity, whereby the maximum load being exerted by the probe element (27) to the contact point of a circuit board is limited to a predetermined value.

2. The test probe as set forth in claim 1,
**characterized in that**
said permanently premagnetized core (17) is fixed and said solenoid element is movable and mechanically connected to said probe element.

3. The test probe as set forth in claim 1 or 2,
**characterized in that**
said solenoid element (20) and said probe element (27) are components of a unit movable in said test probe (1), whose mass is smaller than 10 g and preferably smaller than 5 g.

4. The test probe as set forth in claims 1 to 3,
**characterized in that**
said solenoid element (27) is arranged vertically shiftable on said core (17).

5. The test probe as set forth in claims 1 to 4,
**characterized in that**
said core (17) is a permanent magnet.

6. The test probe as set forth in any of the claims 1 to 4,
**characterized in that**
said core (17) is configured of a soft magnetic material and at least one magnet (13, 14) is provided which is magnetically connected to said core (17) so that said core (17) is permanently premagnetized, and
that said core (17) is arranged between two plate-shaped permanent magnets (13, 14), said core (17) and said permanent magnets (13, 14) being connected to each other magnetically at their upper and lower edges via a yoke (10, 12).

7. The test probe as set forth in claim 6,
**characterized in that**
said plate-shaped permanent magnets (13, 14) form side walls and one of said two yokes (12) a bottom wall of a housing (11) and the other yoke (10) forming a horizontally mounting plate of a support (5) securable to a slide (2).

8. The test probe as set forth in any of the claims 1 to 7,
**characterized in that**
said solenoid element comprises a tubular supporting body made of a thin sheet of aluminum and a solenoid wound around said supporting body.

9. The test probe as set forth in any of the claims 1 to 8,
**characterized in that**
a stop is provided for limiting the travel of said solenoid element (20) so that on movement of said solenoid element for contacting said probe element (27) with a contact point of a circuit board under test said solenoid element (20) is shifted against said stop.

10. The test probe as set forth in any of the claims 1 to 9,
**characterized in that**
the thickness of said wire is less than 50 µm.

11. The test probe as set forth in claim 10,
**characterized in that**
said guide passage (28) incorporates at least three cavities (35) arranged on a regular center-spacing

12. The test probe as set forth in claim 10 or 11,
**characterized in that**
said guide passage (28) is configured in a probe head (36), said probe head comprising a plastics body (29) and two ceramic pads (30, 31).

13. The test probe as set forth in claim 12,
**characterized in that**
said plastics body (29) comprises a roughly triangular cross-section as viewed from above, one vertically oriented edge of said plastics body (29) forming a narrow guide flat (32) and said ceramic pads (30, 31) being secured to the side surface areas adjoining said guide flat (32) and protruding therefrom, they converging at an acute angle to each other so that said guide flat (32) and said ceramic pads (30, 31) define said guide passage (28).

14. The test probe as set forth in claim 13,
**characterized in that**
said guide flat (32) is configured corrugated in side-view so that said guide passage (28) is provided with said cavities (28).

15. A method for activating a test probe configured as set forth in any of the claims 1 to 14,
**characterized in that**
said solenoid element is supplied with a constant holding current in a zero position so that said solenoid element is shifted by a predetermined stroke relative to a contact position of said solenoid element (20) defined by a stop and
a current opposite in polarity to that of said holding current is applied so that said solenoid element (20) is shifted against said stop for contacting a contact point of a circuit board.

16. A finger tester for testing circuit boards including
a test probe configured as set forth in any of the claims 1 to 14,
at least two slides (2) horizontally shiftable over a test area, a test probe being securable to each slide, and
a means for adjusting the vertical position of said test probe (1),
**characterized in that**
said test probe (1) comprises an actuator capable of actuating a probe element (27) independently of said means for adjusting said vertical position of said test probe (1) in the vertical direction for contacting a contact point of a circuit board.

17. The finger tester as set forth in claim 16,
**characterized in that**
the working stroke of said actuator implemented to contact a contact point is smaller than 2 mm and preferably is smaller than 1 mm.

18. The finger tester as set forth in claim 16 or 17, wherein a plurality of test probes is provided in a matrix array, said complete matrix array being moved horizontally over a circuit board under test and each test probe being actuatable by an actuator to actuate one probe element each in the vertical direction, said test probes being actuatable independently of each other and configured as set forth in any of the claims 1 to 14.

19. The finger tester as set forth in any of the claims 16 to 18, wherein a plurality of test probes is provided in a matrix array, said complete matrix array being moved horizontally over a circuit board under test and each test probe being actuatable by an actuator to actuate one probe element each in the vertical direction, said test probe is an elastic wire guided in a guide passage provided with at least one cavity into which said wire is able to curve when loaded.

20. The finger tester as set forth in claim 18 or 19,
**characterized in that**
said matrix array is divided into several sub-matrixes, said sub-matrixes being configured shiftingly relative to each other.

21. The finger tester as set forth in any of the claims 16 to 20,
**characterized in that**
several probe elements are actuatable by a single actuator.

## Revendications

1. Sonde de test pour un testeur à doigts, comportant
un élément de sonde (27) pour mettre en contact électriquement un point de contact d'une carte à circuits imprimés (37) à tester,
un actionneur avec un noyau (17) préaimanté de façon permanente et un élément de bobine (20), lesquels sont mobiles l'un par rapport à l'autre, une des deux parties étant fixée et l'autre partie étant mobile,
la partie mobile étant reliée mécaniquement à l'élément de sonde (27) de telle sorte qu'en cas de commutation de courant, la partie mobile est déplacée conjointement avec l'élément de sonde (27),
la partie mobile est agencée sur la partie fixe de manière librement mobile, et
**caractérisée en ce que**
l'élément de sonde est un fil (27) élastique qui est guidé dans un canal de guidage pourvu de plusieurs évidements (35) dans lesquels le fil peut fléchir en cas de charge, la rigidité du fil et la géométrie de l'évidement étant définies de telle sorte qu'en cas d'actionnement de l'actionneur avec une force prédéterminée, le fil (27) est fléchi dans un premier évidement, et en cas d'une poursuite de l'actionnement de l'actionneur, le fil est fléchi dans un deuxième évidement, grâce à quoi la force exercée au maximum par l'élément de sonde (27) sur le point de contact d'un point d'une carte à circuits imprimés est limitée à une valeur prédéterminée.

2. Sonde de test selon la revendication 1, **caractérisée en ce que** le noyau préaimanté (17) est fixé, et l'élément de bobine est mobile et est relié mécaniquement à l'élément de sonde.

3. Sonde de test selon la revendication 1, **caractérisée en ce que** l'élément de bobine (20) et l'élément de sonde (27) font partie d'une unité mobile dans la sonde de test (1), dont la masse est inférieure à 10 g et de préférence inférieure à 5 g.

4. Sonde de test selon l'une des revendications 1 à 3, **caractérisée en ce que** l'élément de bobine (27) est agencé sur le noyau (17) de manière à se déplacer verticalement.

5. Sonde de test selon l'une des revendications 1 à 4, **caractérisée en ce que** le noyau (17) est un aimant permanent.

6. Sonde de test selon l'une des revendications 1 à 4, **caractérisée en ce que** le noyau est réalisé en matériau magnétique doux et il est prévu au moins un aimant (13, 14) qui est relié magnétiquement au noyau (17), de sorte que le noyau (14) est préaimanté de façon permanente, et
**en ce que** le noyau (17) est agencé entre deux aimants permanents (13, 14) en forme de plaques, le noyau (17) et les aimants permanents (13, 14) étant chacun reliés magnétiquement mutuellement sur leur face supérieure et sur leur face inférieure via une culasse (10, 12).

7. Sonde de test selon la revendication 6, **caractérisée en ce que** les aimants permanents (13, 14) en forme de plaques forment les parois latérales et l'une des deux culasses (12) forme une paroi de fond d'un boîtier (11), et l'autre culasse (10) forme une plaque de retenue horizontale d'une monture (5) susceptible d'être fixée sur un chariot (2).

8. Sonde de test selon l'une des revendications 1 à 7, **caractérisée en ce que** l'élément de bobine est constitué par un corps portant tubulaire réalisé en une tôle d'aluminium mince et par une bobine enroulée sur le corps portant.

9. Sonde de test selon l'une des revendications 1 à 8, **caractérisée par** une butée qui est prévue pour limiter la course de mouvement de l'élément de bobine (20), de sorte que lors du mouvement de l'élément de bobine pour mettre en contact l'élément de sonde (27) avec un point de contact d'une carte à circuits imprimés à tester, l'élément de bobine (20) est déplacé contre la butée.

10. Sonde de test selon l'une des revendications 1 à 9, **caractérisée en ce que** l'épaisseur du fil est inférieure à 50 µm.

11. Sonde de test selon l'une des revendications 10, **caractérisée en ce que** sur le canal de guidage (28) sont prévus au moins trois évidements (35) qui sont agencés avec une distance régulière.

12. Sonde de test selon la revendication 10 ou 11, **caractérisée en ce que** le canal de guidage (28) est réalisé dans une tête de sonde (36) qui présente un corps en matière plastique (29) et deux plaquettes en céramique (30, 31).

13. Sonde de test selon la revendication 12, **caractérisée en ce que** le corps de matière plastique (29) présente une section transversale de forme approximativement triangulaire en vue de dessus, une arête s'étendant à la verticale, du corps en matière plastique (29), étant aplatie pour former une surface de guidage (32) étroite, et les plaquettes en céramique (30, 31) étant fixées sur les surfaces latérales adjacentes de la surface de guidage (32) et faisant saillie sur la surface de guidage (32), ces plaquettes de céramique convergeant en pointe l'une vers l'autre, de sorte que la surface de guidage (32) et les plaquettes de céramique (30, 31) limitent le canal de guidage (28).

14. Sonde de test selon la revendication 13, **caractérisée en ce que** la surface de guidage (32) est réalisée de forme ondulée en vue de côté, de sorte que le canal de guidage (28) est pourvu des évidements (35).

15. Procédé de pilotage d'une sonde de test, dans lequel on utilise une sonde de test selon l'une des revendications 1 à 14, **caractérisé en ce que** dans une position zéro, l'élément de bobine est alimenté avec un courant de maintien constant, de telle sorte que l'élément de bobine est déplacé d'une course prédéterminée par rapport à une position de contact, limitée par une butée, de l'élément de bobine (20), et
**en ce que** pour mettre en contact un point de contact d'une carte à circuits imprimés, l'élément de bobine (20) est alimenté par un courant polarisé à l'opposé du courant de maintien, de telle sorte que l'élément de bobine (20) est déplacé contre la butée.

16. Testeur à doigts pour tester des cartes à circuits imprimés, comportant une sonde de test qui est réalisée selon l'une des revendications 1 à 14,
au moins deux chariots (2) déplaçables à l'horizontale au-dessus d'un champ de test, sur chacun desquels peut être fixée une sonde de test, et un dispositif de réglage de la position verticale de la sonde de test (1),
**caractérisé en ce que**
la sonde de test (1) présente un actionneur qui peut actionner un élément de sonde (27) indépendamment du dispositif de réglage de la position verticale de la sonde de test (1) en direction verticale pour mettre en contact un point de contact d'une carte à circuits imprimés.

17. Testeur digital selon la revendication 16, **caractérisé en ce que** la course de travail de l'actionneur exécutée pour mettre en contact un point de contact, est inférieure à 2 mm et de préférence inférieure à 1 mm.

18. Testeur digital selon la revendication 16 ou 17, dans lequel une multitude de sondes de test sont prévues dans un agencement matriciel, l'ensemble de l'agencement matriciel étant déplacé à l'horizontale au-dessus d'une carte à circuits imprimés à tester, et chaque sonde de test peut être actionnée par un actionneur pour actionner un élément de sonde respectif en direction verticale, dans lequel les sondes de test peuvent être actionnées indépendamment les unes des autres et sont réalisées selon l'une des revendications 1 à 14.

19. Testeur digital selon l'une des revendications 16 à 18, dans lequel une multitude de sondes de test sont prévues dans un agencement matriciel, l'ensemble de l'agencement matriciel étant déplacé à l'horizontale au-dessus d'une carte à circuits imprimés à tester, et chaque sonde de test peut être actionnée par un actionneur pour actionner un élément de sonde respectif en direction verticale, et en ce que l'élément de sonde est un fil élastique qui est guidé dans un canal de guidage, canal qui est pourvu d'au moins un évidement dans lequel le fil peut fléchir en cas de sollicitation.

20. Testeur digital selon la revendication 18 ou 19, **caractérisé en ce que** l'agencement matriciel est divisé en plusieurs matrices partielles, les matrices partielles étant réalisées déplaçables les unes par rapport aux autres.

21. Testeur digital selon l'une des revendications 16 à 20, **caractérisé en ce que** plusieurs éléments de sonde peuvent être actionnés par un unique actionneur.
